**Europäisches Patentamt**

**European Patent Office**

**Office européen des brevets**

(19)

(11) Numéro de publication: **0 138 634 B1**

# FASCICULE DE BREVET EUROPEEN

(12)

(45) Date de publication du fascicule du brevet:
**03.06.87**

(51) Int. Cl.⁴: **H 05 K 7/02,** H 02 B 1/08,
**H 01 H 13/50**

(21) Numéro de dépôt: **84401599.0**

(22) Date de dépôt: **30.07.84**

(54) Dispositif d'assemblage de modules d'appareillage électrique.

(30) Priorité: **17.08.83 FR 8313466**

(43) Date de publication de la demande:
**24.04.85 Bulletin 85/17**

(45) Mention de la délivrance du brevet:
**03.06.87 Bulletin 87/23**

(84) Etats contractants désignés:
**BE CH DE GB IT LI NL SE**

(56) Documents cités:
**DE - A - 2 815 215**
**FR - A - 2 491 284**
**US - A - 3 289 852**

(73) Titulaire: **MERLIN GERIN, Rue Henri Tarze,
F-38050 Grenoble Cédex (FR)**

(72) Inventeur: **Vasseur, André, 13, Avenue Jacques Brel,
B-7400 Soignies (BE)**

(74) Mandataire: **Kern, Paul et al, Merlin Gerin Sce.
Brevets 20, rue Henri Tarze, F-38050 Grenoble Cedex
(FR)**

## Description

L'invention est relative à un dispositif d'assemblage de modules, notamment de deux boîtiers moulés, accolés, de logement d'appareillage électrique, comprenant une pièce de liaison encliquetable maintenant, en position encliquetée, les deux boîtiers accolés.

Un dispositif d'assemblage du genre mentionné, décrit dans le brevet français n° 2 411 329, comprend une pièce de liaison insérée dans un alvéole de l'un des boîtiers et encliquetée sur le boîtier accolé. Ce mode de liaison convient à la fixation d'un module ou bloc auxiliaire et la pièce de liaison est montée sur la face latérale accolée au module adjacent. L'assemblage de ce module auxiliaire par sa face opposée nécessite un changement de côté des pièces de liaison. Le montage de ces pièces, maintenues par un ressort, est délicat et la pièce peut se détacher et se perdre. Le gabarit d'un élément équipé des pièces de liaison est différent de celui d'un élément démuni de ces pièces, ce qui complique l'emballage.

La présente invention a pour but de remédier à ces inconvénients et de réaliser un dispositif d'assemblage universel simple.

Le dispositif d'assemblage selon l'invention est caractérisé en ce que ladite pièce de liaison en forme de coulisseau en un matériau isolant est montée à coulissement dans des glissières ménagées dans lesdits boîtiers, lesdits glissières étant alignées en position accolée des boîtiers et présentant des saillies d'encliquetage dudit coulisseau.

L'emploi d'une pièce isolante évite toute propagation de potentiels dangereux et permet la disposition de la pièce de liaison à proximité de pièces sous tension notamment des bornes de connexion. Le coulisseau est logé dans une rainure en forme de glissière du boîtier, sans augmentation du gabarit de ce boîtier. Chaque module, par exemple chaque boîtier miniature d'un système modulaire d'appareillage électrique, peut être équipé d'un coulisseau monté en usine sur les boîtiers fermés ou mis en place par l'utilisateur ou l'installateur en cas de besoin. Le coulisseau est amené en saillie du côté du module à accoler et ce dernier est encliqueté sur le coulisseau, ou de préférence sur les deux coulisseaux disposés de part et d'autre du module. Il est également possible d'accoler d'abord les modules et de glisser le coulisseau en position d'encliquetage sur les modules accolés. Les modules sont montés sur un support, notamment par encliquetage sur un rail DIN, la ou les pièces de liaison maintenant les modules accolés et renforçant la liaison.

Le coulisseau et la glissière présentent un plan de symétrie correspondant au plan transversal de symétrie du boîtier, et un assemblage d'un côté ou de l'autre s'effectue exactement de la même manière en déplaçant le coulisseau dans un sens ou dans l'autre. Le coulisseau est maintenu dans la glissière par un profil en queue d'aronde et les saillies d'encliquetage sont ménagées dans le fond de la glissière. L'encliquetage s'effectue par une déformation élastique de l'extrémité du coulisseau en forme de crochet ou de nez qui vient se clipser sur une saillie ou un bossage conjugué.

Le coulisseau monté sur le boîtier est imperdable car les deux saillies le maintiennent en une position médiane. L'ensemble est simple et assure un positionnement précis des pièces assemblées, dont seul le boîtier a été modifié pour présenter une ou plusieurs glissières de logement de coulisseaux, notamment sur les faces latérales du boîtier au-dessus des bornes.

D'autres avantages et caractéristiques ressortiront plus clairement de la description qui va suivre d'un mode de mise en oeuvre de l'invention donné à titre d'exemple non limitatif et représenté aux dessins annexés dans lesquels:

la figure 1 est une vue schématique en perspective de modules selon l'invention en cours d'assemblage;

la figure 2 est une vue en perspective d'un coulisseau d'assemblage selon la figure 1;

la figure 3 est une vue partielle en perspective d'un coulisseau monté sur un module;

les figures 4 à 7 sont des vues en coupe du coulisseau et de la glissière représentés respectivement en position centrale, en position décalée latéralement, en cours d'assemblage et en position assemblée.

Sur les figures des modules ou blocs, en l'occurrence des boîtiers moulés 10, 12, 14, 16 de disjoncteurs miniatures, formés de deux demi-coquilles assemblées suivant un plan de symétrie de trace 17 sur les figures, contiennent chacun les éléments constitutifs d'un pôle de coupure et peuvent être accolés et assemblés pour constituer un bloc multipolaire. Chaque module 10-16 est encliqueté par sa face arrière 18 sur un rail DIN symétrique de support et porte sur la face avant une manette de commande 20. Des bornes de connexion 22 sont disposées sur les faces 24, 26 latérales étroites, tandis que les modules successifs 10-16 sont accolés par leurs grandes faces latérales 28, 30. Le profil des boîtiers est standard et les modules peuvent être des blocs interrupteurs ou des blocs auxiliaires, par exemple des blocs différentiels ou des blocs de signalisation ou de commande, associés aux blocs de coupure. De tels systèmes modulaires sont bient connus des spécialistes et il est inutile de les décrire plus en détail.

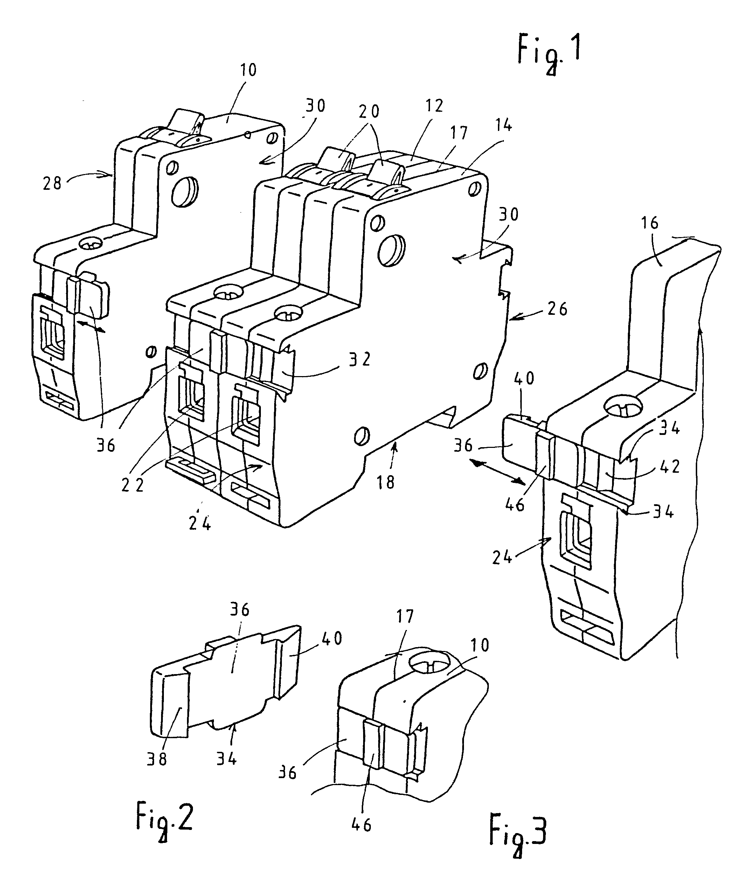

Sur chaque face latérale étroite 24, 26 est ménagé une glissière 32 ou coulisse en forme de rainure, qui s'étend au-dessus des bornes 22, perpendiculairement aux grandes faces 28, 30, sur toute la largeur de la face étroite 24, 26. Dans la glissière 32 est montée à coulissement par un profil 34 en queue d'aronde une pièce de liaison en forme de coulisseau 36 ou de tiroir. La longueur du coulisseau 36 est sensiblement égale ou légèrement inférieure à la largeur de la face étroite 24, 26 afin de ne pas déborder en position inactive centrale représentée à la figure 3.

Le coulisseau 36 en un matériau isolant plastique est retenu dans la glissière 32 par le profil en queue d'aronde 34, prévu dans la partie centrale du coulisseau, tandis que les deux extrémités, chacune conformée en crochet 38, 40, peuvent se déformer élastiquement. Les crochets 38, 40, orientés vers le fond de la glissière 32, coopèrent avec des saillies conjuguées 42, 44, ménagées dans ce fond. La face avant du coulisseau 36 porte une nervure 46 d'actionnement ou tout autre système analogue de préhension.

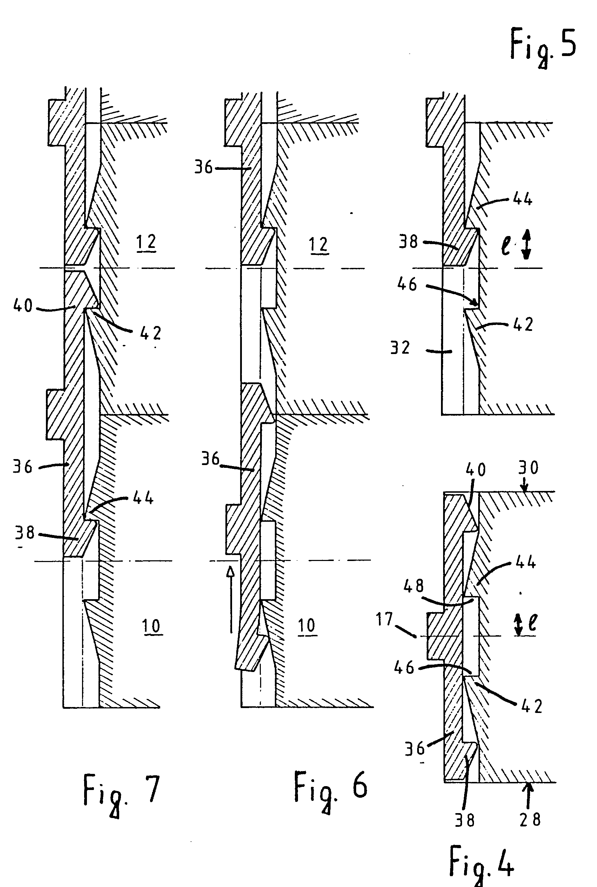

En se référant plus particulièrement aux figures 4

3        **0 138 634**        4

à 7 on voit que le coulisseau 36 et le fond de la glissière 32, portant les saillies 42-44, en forme de dents de scie, sont symétriques par rapport au plan de trace 17, parallèle aux grandes faces latérales 28, 30 du boîtier. Les fronts raides 46, 48 des saillies 42, 44 se font face de part et d'autre du plan 17 à une distance «1» de ce plan suffisante au logement du crochet 38, en position décalée du coulisseau 36 (figure 5). Les plans inclinés des saillies 42, 44 sont orientés vers l'extérieur. D'une manière analogue les crochets 38, 40 du coulisseau 36 se font face avec un écartement sensiblement égal à celui des saillies 42, 44 de deux blocs 10, 12 accolés (voir figure 7).

Le fonctionnement du dispositif d'assemblage ressort des figures 4 à 7:

En position centrale du coulisseau 36, représentée à la figure 4, les crochets 38, 40 chevauchent les plans inclinés des saillies 42, 44 en retenant le coulisseau dans cette position centrale. Le coulisseau 36, qui a pu être mis en place en usine après fermeture du boîtier 10, par simple introduction et glissement dans la glissière 32 est imperdable et il est entièrement logé à l'intérieur de cette glissière 32. Lors d'un coulissement du coulisseau 36, par exemple vers la droite sur la figure 4, le crochet 38 se déforme pour franchir la saillie 42 et pour venir s'accrocher sur la saillie 44 dans la position représentée à la figure 5, dans laquelle il libère totalement la partie de la glissière 32 à gauche du plan de symétrie 17. Sur la figure 6 on voit deux modules accolés 10, 12. Le coulisseau 36 du module 12 étant dans la position décalée vers la droite et le coulisseau 36 du module 10 étant en cours de décalage vers la droite vers la position d'encliquetage représentée à la figure 7. Dans cette position le coulisseau 36 encliqueté sur la saillie 44 du module 10 et sur la saillie 32 du module 12 maintient ces deux modules assemblés. Un décrochage peut être réalisé par une déformation des crochets 38, 40, par exemple à l'aide d'un tournevis. Un nombre quelconque de modules 10-16 peuvent ainsi être assemblés, l'ensemble étant symétrique et le coulisseau 36 pouvant être indifféremment déplacé vers la gauche ou vers la droite.

La disposition des glissières 32, des saillies 42, 44 et des crochets 38, 40, peut bien entendu être différente et on ne sortirait pas du cadre de l'invention en ménageant la glissière, par exemple sur la face avant des boîtiers, ou en utilisant un coulisseau en forme de barre traversant un logement ménagé dans le boîtier.

## Revendications

1. Dispositif d'assemblage de modules (10, 12, 14, 16), notamment de deux boîtiers moulés, accolés, de logement d'appareillage électrique, comprenant une pièce de liaison (36) encliquetable maintenant, en position encliquetée, les deux boîtiers accolés, caractérisé en ce que ladite pièce de liaison en forme de coulisseau (36) en un matériau isolant est montée à coulissement dans des glissières (32) ménagées dans lesdits boîtiers, lesdites glissières étant alignées en position accolée des boîtiers et présentant des saillies (42, 44) d'encliquetage dudit coulisseau (36).

2. Dispositif d'assemblage selon la revendication 1, caractérisé en ce que la glissière (32) d'un boîtier (10, 12, 14, 16) s'étend sur la face latérale étroite (24, 26) du boîtier perpendiculairement à l'interface des deux boîtiers accolés, ledit coulisseau (36) chevauchant en position encliquetée ladite interface.

3. Dispositif d'assemblage selon la revendication 1 ou 2, caractérisé en ce que la glissière (32) comporte une rainure de faible profondeur dont le fond est parallèle à la face latérale (24, 26) étroite du boîtier.

4. Dispositif d'assemblage selon la revendication 1, 2 ou 3, caractérisé en ce que la glissière (32) s'étend sur toute la largeur de la face latérale étroite (24, 26) du boîtier, ledit coulisseau (36) étant susceptible d'être déplacé en saillie de l'une ou de l'autre des grandes faces latérales du boîtier.

5. Dispositif d'assemblage selon la revendication 4 de modules présentant un plan de symétrie (17) parallèle à la face (28, 30) d'accolement du boîtier, caractérisé en ce que le boîtier présente deux saillies (42, 44) d'encliquetage disposées symétriquement dudit plan de symétrie, ledit coulisseau (36) présentant également un plan de symétrie pour coopérer indifféremment avec l'une ou l'autre des saillies.

6. Dispositif d'assemblage selon la revendication 5, caractérisé en ce que le coulisseau (36) comporte à chacune de ses extrémités un nez (38, 40) d'encliquetage, l'écartement entre les deux nez correspondant à l'écartement des saillies (42, 44) d'encliquetage conjuguées ménagées sur les deux boîtiers accolés.

7. Dispositif d'assemblage selon la revendication 4, 5 ou 6, caractérisé en ce que les deux saillies (42, 44) d'encliquetage d'un même boîtier sont agencées pour coopérer simultanément l'une avec un coulisseau (36) de liaison d'un module accolé d'un côté, et l'autre avec un coulisseau de liaison d'un module accolé de l'autre côté du boîtier.

8. Dispositif d'assemblage selon l'une quelconque des revendications précédentes, caractérisé en ce que les saillies (42, 44) d'encliquetage sont ménagées sur le fond de la glissière (32), la liaison unidirectionnelle d'encliquetage entre le nez (38, 40) du coulisseau (36) et la saillie (42, 44) empêchant le coulissement du coulisseau vers l'extérieur de la glissière (32) du côté du boîtier accolé.

9. Dispositif d'assemblage selon l'une quelconque des revendications précédentes, de modules fixés par la face arrière sur un rail support et présentant sur la face latérale étroite (24, 26) une borne (22) de connexion électrique, caractérisé en ce que ladite glissière (32) ménagée sur la face latérale étroite (24, 26) s'étend au-dessus de la borne du côté de la face avant du module.

10. Dispositif d'assemblage selon l'une quelconque des revendications précédentes, caractérisé en ce que la longueur du coulisseau (36) est inférieure à la longueur de la glissière (32), le coulisseau étant quasi-totalement inséré dans la glissière en position montée sans augmentation du gabarit du module.

## Patentansprüche

1. Zusammenbauvorrichtung für Module (10, 12, 14, 16), insbesondere für zwei aneinandergefügte Gussgehäuse zur Unterbringung von elektrischen Geräten, mit einem einrastbaren Verbindungsstück (36), welches in eingerasteter Lage die beiden Gehäuse zusammenhält, dadurch gekennzeichnet, dass das schiebeförmige Verbindungsstück (36) aus Isoliermaterial gleitbar in Schienen (32) montiert ist, die in den genannten Gehäusen vorgesehen sind, wobei sich die genannten Schienen in der zusammengefügten Lage der Gehäuse auf einer Ebene befinden und Vorsprünge (42, 44) zum Einrasten des genannten Schiebers (36) aufweisen.

2. Zusammenbauvorrichtung gemäss Anspruch 1, dadurch gekennzeichnet, dass sich die Schiene (32) eines Gehäuses (10, 12, 14, 16) auf der schmalen seitlichen Fläche (24, 26) des Gehäuses erstreckt senkrecht zur Zwischenwand der beiden aneinandergefügten Gehäuse, wobei der genannte Schieber (36) in eingerasteter Lage die genannte Zwischenwand überdeckt.

3. Zusammenbauvorrichtung gemäss Anspruch 1 oder 2, dadurch gekennzeichnet, dass die Schiene (32) eine Rille von geringer Tiefe aufweist, deren Boden parallel zu der schmalen seitlichen Fläche (24, 26) des Gehäuses verläuft.

4. Zusammenbauvorrichtung gemäss Anspruch 1, 2 oder 3, dadurch gekennzeichnet, dass sich die Schiene (32) auf der ganzen Breite der schmalen seitlichen Fläche (24, 26) des Gehäuses erstreckt, wobei der genannte Schieber (36) vorspringend auf die eine oder die andere der grossen seitlichen Flächen des Gehäuses versetzt werden kann.

5. Zusammenbauvorrichtung gemäss Anspruch 4, für Module, die eine Symmetrie-Ebene (17) aufweisen, die parallel zur Verbindungswand (28, 30) des Gehäuses verläuft, dadurch gekennzeichnet, dass das Gehäuse zwei Einrastungsvorsprünge (42, 44) aufweist, die symmetrisch zu der genannten Symmetrie-Ebene angeordnet sind, wobei der genannte Schieber (36) ebenfalls eine Symmetrie-Ebene aufweist, um ohne Unterschied entweder mit dem einen oder dem anderen Vorsprung zusammenzuarbeiten.

6. Zusammenbauvorrichtung gemäss Anspruch 5, dadurch gekennzeichnet, dass der Schieber (36) an jedem seiner Enden eine Einrastungsnase (38, 40) aufweist, wobei der Abstand zwischen den beiden Nasen dem Abstand der zugeordneten Einrastungsvorsprünge (42, 44) entspricht, die auf den beiden aneinandergefügten Gehäusen vorgesehen sind.

7. Zusammenbauvorrichtung nach Anspruch 4, 5 oder 6, dadurch gekennzeichnet, dass die beiden Einrastungsvorsprünge (42, 44) eines selben Gehäuses so ausgebildet sind, dass gleichzeitig der eine mit einem Verbindungsschieber (36) eines auf einer Seite verbundenen Moduls zusammenarbeitet und der andere mit einem Verbindungsschieber eines auf der anderen Seite des Gehäuses verbundenen Moduls zusammenarbeitet.

8. Zusammenbauvorrichtung nach irgend einem der vorigen Ansprüche, dadurch gekennzeichnet, dass die Einrastungsvorsprünge (42, 44) auf dem Boden der Schiene (32) vorgesehen sind, wobei die Ein-Richtungs-Einrastungsverbindung zwischen der Nase (38, 40) des Schiebers (36) und dem Vorsprung (42, 44) das Gleiten des Schiebers aus der Schiene (32) heraus auf der Seite des verbundenen Gehäuses verhindert.

9. Zusammenbauvorrichtung nach irgend einem der vorigen Ansprüche für Module, die mit der Hinterseite auf einer Stützschiene befestigt sind, und die auf der schmalen Seitenfläche (24, 26) eine elektrische Verbindungsklemme (22) aufweisen, dadurch gekennzeichnet, dass sich die genannte auf der schmalen Seitenfläche (24, 26) vorgesehene Schiene (32) über der Klemme erstreckt auf der Vorderseite des Moduls.

10. Zusammenbauvorrichtung nach irgend einem der vorigen Ansprüche, dadurch gekennzeichnet, dass die Länge des Schiebers (36) geringer als die Länge der Schiene (32) ist, wobei der Schieber in montierter Lage praktisch ganz in der Schiene eingefügt ist, ohne Erhöhung der Modul-Abmessungen.

## Claims

1. Assembling device for modules (10, 12, 14, 16), particularly for two moulded coupled casings for the housing of electrical equipment, comprising a ratchable connecting part (36) holding the two coupled casings in ratched position, characterized in that said connecting part is in the form of a slide (36) in insulating material being mounted to move in a sliding manner in runners (32) fitted in the casings, these runners being aligned when the casings are coupled and incorporate ratching notches (42, 44) for the slide (36).

2. Assembling device according to claim 1, characterized by the fact that the runner (32) of a casing (10, 12, 14, 16) extends over the narrow side face (24, 26) of the casing in a manner perpendicular to the interface of the two coupled casings, the slide (36) over-lapping this interface when in the ratched position.

3. Assembling device according to claim 1 or 2, characterized by the fact that the runner (32) has incorporated a shallow groove, the bottom of which is parallel to the narrow side face (24, 26) of the casing.

4. Assembling device according to claim 1, 2 or 3, characterized by the fact that the runner (32) extends over the whole width of the narrow side face (24, 26) of the casing, the slide (36) being capable of being moved projecting from one or the other of the large side faces of the casing.

5. Assembling device according to claim 4 for modules with a plane of symmetry (17) parallel to the coupling face (28, 30) of the casing, characterized by the fact that the casing incorporates two ratching notches (42, 44) placed symmetrically with regard to the plane of symmetry of the module, the slide (36) also having a plane of symmetry to work in conjunction indifferently with one or the other of the notches.

6. Assembling device according to claim 5, characterized by the fact that the slide (36) has a ratching nose (38, 40) at each of its edges, the distance between both noses corresponding to the distance between the interlocking ratching notches (42, 44) fitted on the two coupled casings.

7. Assembling device according to claim 4, 5 or 6, characterized by the fact that the two ratching notches (42, 44) of the same casing are arranged to work in simultaneous conjunction, the one with the connecting slide (36) of a module coupled one side, and the other with a connecting slide of a module coupled the other side of the casing.

8. Assembling device according to any one of the claims above, characterized by the fact that the ratching notches (42, 44) are fitted in the bottom of the runner (32), the unidirectional ratching connection between the nose (38, 40) of the slide (36) and the notch (42, 44) preventing the movement of the slide towards the outside of the runner (32) the side of the coupled casing.

9. Assembling device according to any one of the claims above for modules fixed by the rear face on a support rail and having on the narrow side face (24, 26) an electrical connection terminal (22), characterized by the fact that the runner (32) fitted on the narrow side face (24, 26) extends above the terminal the side of the front face of the module.

10. Assembling device according to any one of the claims above, characterized by the fact that the length of the slide (36) is smaller than the length of the runner (32), the slide being almost totally inserted in the runner when in the mounted position without any increase of outline framework of the module.

Fig.1

Fig.2

Fig.3

Fig. 5

Fig. 7

Fig. 6

Fig. 4